# EUROPEAN PATENT APPLICATION

(11) **EP 4 815 681 A1**
(43) Date of publication of application: **30.09.2026**
(21) Application number: 26166120.1
(22) Date of filing: 19.03.2026
(51) Int. Cl.: H10F 39/10, H10F 39/00

(54) **PIXEL ARRAY AND IMAGE SENSOR INCLUDING THE SAME**

(30) Priority: 19.03.2025 KR 20250035597; 21.05.2025 KR 20250066446; 14.01.2026 KR 20260007459
(71) Applicant: LX Semicon Co., Ltd., Daejeon 34027 (KR)
(72) Inventor: OH, Namhoon, 34027 Daejeon (KR); LEE, JongKwon, 34027 Daejeon (KR)
(74) Representative: Ter Meer und Partner mbB

(57) **Abstract**

An embodiment of the present invention provides a pixel array comprising: a plurality of pixels, wherein each of the plurality of pixels comprises: a substrate including an avalanche amplification region and having a first surface on which light from the outside is incident; and a plasmonic pattern formed on the first surface of the substrate, wherein the plasmonic pattern includes one or more holes.

## Description

This application claims the benefit of priority of the Korean Patent Application No. 10-2025-0035597 filed on March 19, 2025, No. 10-2025-0066446 filed on May 21, 2025, and No. 10-2026-0007459 filed on January 14, 2026.

### BACKGROUND

### Field of the Invention

The present invention relates to a pixel array and an image sensor including the same.

### Discussion of the Related Art

Recently, in various application fields such as video recording, digital cameras, smartphones, and automotive ADAS (Advanced Driver Assistance Systems), the demand for high-resolution and high-performance image sensors has been rapidly increasing. An image sensor is a semiconductor device that converts light (optical signals) received from an object into electrical signals. Generally, it includes a pixel array composed of a plurality of pixels, and a signal processing circuit configured to read signals generated from each pixel.

Meanwhile, as the demand for image sensors capable of detecting wavelengths in the SWIR (Short-Wavelength Infrared) region increases, image sensors using group III-V compound semiconductors (e.g., InGaAs) have conventionally been mainly used. However, such InGaAs-based sensors have high manufacturing costs and low compatibility with existing CMOS processes, thereby limiting the implementation of large-area arrays and mass production.

Accordingly, in recent years, research has been conducted on technologies capable of securing sensitivity in the SWIR region while maintaining conventional CMOS processes.

### SUMMARY

One embodiment of the present invention is directed to providing a pixel array in which light absorption efficiency at SWIR wavelengths is maximized by inducing wavelength conversion using a plasmonic pattern structure.

Another embodiment of the present invention is directed to providing an image sensor including such a pixel array.

An embodiment of the present invention for achieving the above-described technical object is directed to providing a pixel array including a plurality of pixels, wherein each of the plurality of pixels includes: a substrate including an avalanche amplification region and having a first surface on which light from the outside is incident; and a plasmonic pattern formed on the first surface of the substrate, wherein the plasmonic pattern includes one or more holes.

Another embodiment of the present invention is directed to providing an image sensor including: a plurality of pixels; and a pixel isolation structure separating the plurality of pixels from one another, wherein each of the plurality of pixels includes: a substrate disposed on a readout circuit and having a first surface on which light from the outside is incident; and a plasmonic pattern formed on the first surface of the substrate, wherein the plasmonic pattern includes a plurality of holes.

In one or more embodiments, one plasmonic pattern may be disposed for each of the plurality of pixels.

In one or more embodiments, the plasmonic pattern disposed in any one of the plurality of pixels may be formed as an integral structure.

In one or more embodiments, the plasmonic pattern may include a plurality of holes arranged in a predetermined direction.

In one or more embodiments, the plurality of holes may be spaced apart from each other.

In one or more embodiments, the hole may have a first length in a first direction, and a second length different from the first length in a second direction perpendicular to the first direction.

In one or more embodiments, one of the first length and the second length may be at least three times greater than the other.

In one or more embodiments, in a plan view, the pixel may include a first region and a second region different from each other.

In one or more embodiments, the plasmonic pattern may include a plurality of holes disposed in the first region and the second region.

In one or more embodiments, the plurality of holes disposed in the first region and the plurality of holes disposed in the second region may extend in directions perpendicular to each other.

In one or more embodiments, the hole may have a square shape in a plan view or has a circular shape having a constant radius in a plan view.

In one or more embodiments, when a wavelength of incident light is λ, a width of the hole may be in a range from λ/4 to λ/1.5.

In one or more embodiments, the width of the hole may be in a range from 400 nm to 1,000 nm.

In one or more embodiments, the pixel array may comprise a barrier layer disposed between the substrate and the plasmonic pattern and being in contact with the first surface of the substrate and the plasmonic pattern.

In one or more embodiments, the pixel array may comprise a dielectric layer disposed on the plasmonic pattern and filling the hole.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 is a block diagram of an image sensor according to the present invention.
FIG. 2 is a plan view of a pixel array according to the present invention.
FIG. 3 is a plan view showing an arrangement of doping regions in the pixel array of FIG. 2.
FIG. 4 is a cross-sectional view taken along line I-I' of FIG. 2.
FIG. 5 is a plan view of a pixel array according to another embodiment of FIG. 2.
FIG. 6 is a cross-sectional view taken along line II-II' of FIG. 5.
FIG. 7 is a plan view of a pixel array according to another embodiment of FIG. 2.
FIG. 8 is a table showing wavelength conversion according to an aspect ratio of a hole.
FIG. 9 is a table showing wavelength conversion according to a width of a hole.

### DETAILED DESCRIPTION OF THE DISCLOSURE

The advantages and features of the present invention, and the methods for achieving them, will become apparent with reference to the embodiments described in detail below in conjunction with the accompanying drawings. However, the present invention is not limited to the embodiments disclosed hereinafter and may be implemented in various different forms. The present embodiments are provided only to ensure that the disclosure of the present invention is complete and to fully inform those skilled in the art of the scope of the invention.

The shapes, sizes, ratios, angles, numbers, and the like disclosed in the drawings for describing embodiments of the present invention are illustrative only, and the present invention is not limited to the matters shown in the drawings. Throughout the specification, identical components may be designated by identical reference numerals. Further, in describing the present invention, when it is determined that a detailed description of related known technology may unnecessarily obscure the gist of the present invention, the detailed description thereof will be omitted.

**In** this specification, when the terms "include," "have," or "consist of" are used, other elements may be added unless the expression "only" is used. When a component is expressed in the singular, it is intended to include the plural unless explicitly stated otherwise.

In interpreting components, it is to be understood that they include error ranges even if not expressly stated.

For example, when the positional relationship between two elements is described using terms such as "on," "above," "below," or "next to," one or more other elements may be interposed between the two elements unless the expression "directly" or "immediately" is used.

Spatially relative terms such as "below," "beneath," "lower," "above," and "upper" may be used to facilitate description of the relationship of one element or component to another element or component as illustrated in the drawings. Spatially relative terms are intended to encompass different orientations of the device in use or operation in addition to the orientation depicted in the drawings. For example, if a device in the drawings is turned over, elements described as "below" or "beneath" other elements would then be oriented "above" the other elements. Accordingly, the exemplary term "below" may include both below and above directions. Similarly, the exemplary terms "above" or "upper" may include both above and below directions.

When describing temporal relationships, for example, when the order of time is described as "after," "following," "next," or "before," such descriptions may include non-consecutive cases unless the expression "immediately" or "directly" is used.

Although terms such as "first" and "second" may be used to describe various elements, these elements are not limited by such terms. These terms are used only to distinguish one element from another. Accordingly, a first element referred to below may also be a second element within the technical scope of the present invention.

The term "at least one" should be understood to include all possible combinations that can be made from one or more associated items. For example, "at least one of a first item, a second item, and a third item" may mean any one of the first, second, or third items, as well as any combination of two or more of the first, second, and third items.

Features of the various embodiments of the present invention may be partially or entirely combined or associated with each other, and various technical interactions and operations are possible. Each embodiment may be implemented independently or may be implemented together in an associated relationship.

In assigning reference numerals to components in the drawings describing embodiments of the present invention, identical components may be assigned identical reference numerals as much as possible, even if they are illustrated in different drawings.

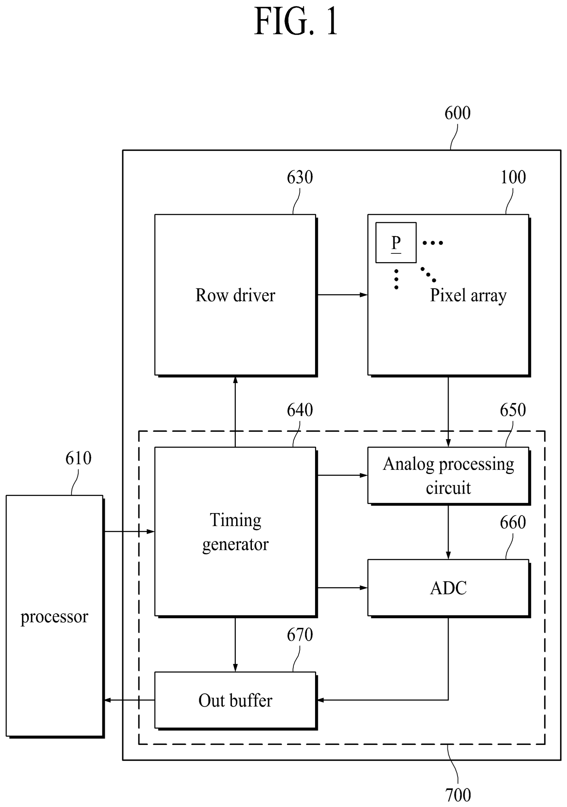

FIG. 1 is a block diagram of an image sensor (600) including a pixel array (100). As shown in FIG. 1, the image sensor (600) including the pixel array (100) according to an embodiment of the present invention emits an optical signal to an object and converts an optical signal reflected from the object into an electrical signal, and outputs the electrical signal to a processor (610) of an electronic device (not shown) to which the image sensor (600) is applied.

In this case, as described above, the electronic device may include, in addition to an automotive LiDAR sensor, a tablet PC, or a portable terminal, a camera, a wearable device, an Internet of Things (IoT) device, a home appliance, a robot, a robot vacuum cleaner, a portable multimedia player (PMP), a navigation device, a drone, and an Advanced Driver Assistance System (ADAS). In addition, the electronic device may be a device incorporated as a component in a vehicle, furniture, manufacturing equipment, a door, or various measuring instruments.

As shown in FIG. 1, the image sensor (600) includes the pixel array (100), a row driver (630), a timing generator (640), an analog processing circuit (650), an analog-to-digital converter (660), and an output buffer (670).

The readout circuit (700) according to the present invention may include the timing generator (640), the analog processing circuit (650), the analog-to-digital converter (660), and the output buffer (670). The readout circuit (700) may collect photocharges from a plurality of pixels (P) on a row-by-row basis.

The pixel array (100) includes a plurality of pixels (P). The plurality of pixels (P) may be arranged in a two-dimensional array. For example, the plurality of pixels (P) may be arranged in a matrix form including M rows (where M is an integer of 2 or more) and N columns (where N is an integer of 2 or more). Each pixel (P) included in the pixel array (100) detects an optical signal using a single-photon avalanche diode (SPAD) and converts the optical signal into an electrical signal, i.e., a pixel signal.

Each pixel (P) may be driven by control signals received from the row driver (630). The signal converted by each pixel (P) and a reset signal corresponding to a reset component are provided to the analog processing circuit (650).

The row driver (630) drives each of the pixels (P) included in the pixel array (100) based on control by the timing generator (640). In one embodiment, the row driver (630) may control all of the pixels (P) in the pixel array (100) simultaneously, or may control the unit pixels (P) of the pixel array (100) on a row-by-row basis. To this end, the row driver (630) may transmit control signals to the pixels (P).

In one embodiment, the row driver (630) may transmit control signals to each pixel (P) under the control of the timing generator (640).

The timing generator (640) may control the pixel array (100) through the row driver (630), and may output control signals for controlling the analog processing circuit (650), the analog-to-digital converter (660), and the output buffer (670).

The analog processing circuit (650) may sample and hold an output signal provided from the pixel (P) according to a correlated double sampling (CDS) scheme, and may double-sample specific noise levels, such as a reset level and a signal level.

The analog processing circuit (650) may generate a comparison result signal corresponding to a reset level and a comparison result signal corresponding to a signal level. Here, a method of reading out the reset level and then reading out the signal level may be referred to as a complete CDS (Correlated Double Sampling) scheme, and a method of reading out the signal level and then reading out the reset level may be referred to as an incomplete CDS (in-complete CDS) scheme or a DRS (Delta Reset Sampling) scheme.

The analog-to-digital converter (660) may convert an output signal from the analog processing circuit (650) into a digital signal and provide the digital signal to the output buffer (670). Although FIG. 1 illustrates the analog processing circuit (650) and the analog-to-digital converter (660) as separate components, in another embodiment, the analog-to-digital converter (660) may be included in or integrated with the analog processing circuit (650).

The output buffer (670) may latch the digital signal transmitted from the analog-to-digital converter (660) and sequentially output the latched signal.

The processor (610) of the electronic device may perform signal processing on the digital signal output from the output buffer (670) and output the processed signal to an external device or store it in a storage device such as a memory.

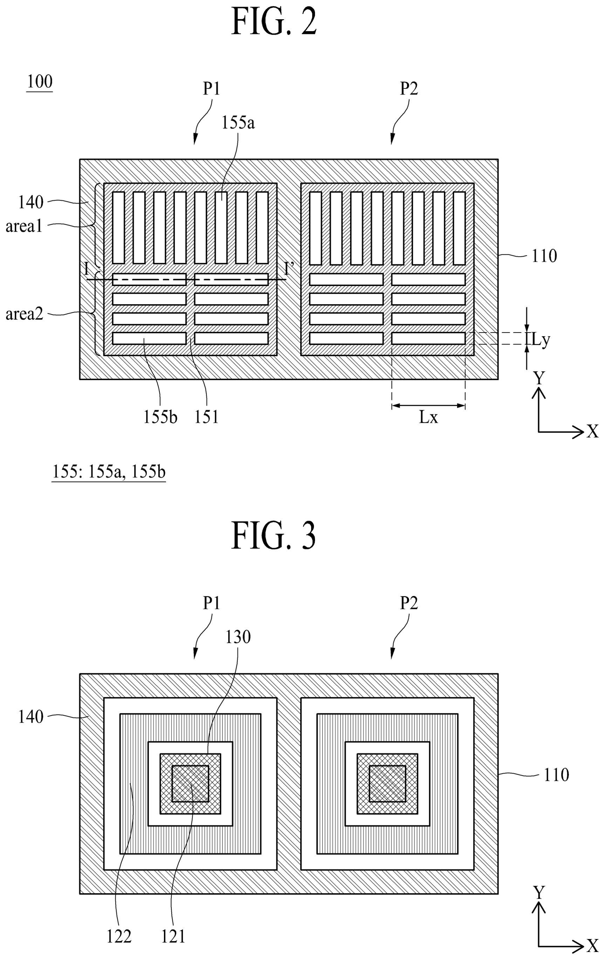

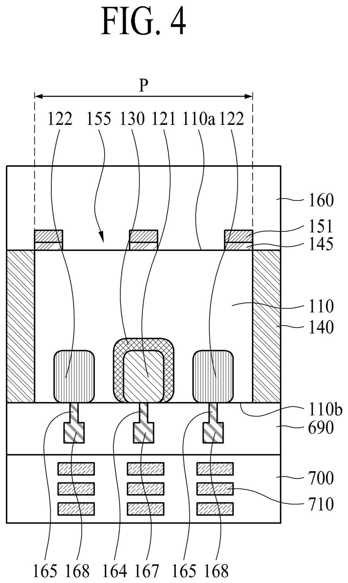

FIG. 2 is a plan view of a pixel array according to the present invention. FIG. 3 is a plan view showing the arrangement of doping regions in the pixel array of FIG. 2. FIG. 4 is a cross-sectional view taken along line I-I' of FIG. 2.

Referring to FIGS. 2 to 4, the pixel array (100) may include a first pixel (P1), a second pixel (P2), and a pixel isolation structure (140) surrounding each of the first pixel (P1) and the second pixel (P2).

The plan view shown in FIG. 3 illustrates a state in which the plasmonic pattern (151) is not disposed in FIG. 2.

The cross-sectional structure of the first pixel (P1) shown in FIG. 4 may correspond to the cross-sectional structure of the second pixel (P2) shown in FIGS. 2 and 3.

As shown in FIGS. 2 to 4, the pixel array (100) according to an embodiment of the present invention includes a plurality of pixels (P1, P2), and each of the plurality of pixels (P1, P2) includes a substrate (110). The substrate (110) has a first surface (110a) and a second surface (110b). In one embodiment, the first surface (110a) of the substrate (110) may be a surface on which light is incident from the outside, and the second surface (110b) of the substrate (110) may be opposite to the first surface (110a). In the present invention, the first surface (110a) may be an upper surface of the substrate (110), and the second surface (110b) may be a lower surface of the substrate (110). The substrate (110) may be a silicon (Si) substrate.

The substrate (110) may be a region lightly doped with a dopant of a first conductivity type or a dopant of a second conductivity type, and may be formed by epitaxial growth. When the substrate (110) is doped with a dopant of the first conductivity type, a PN junction region formed with a first doping region (121), which is doped with a dopant of the second conductivity type opposite to the first conductivity type within the substrate (110), becomes an avalanche amplification region (130).

In one embodiment of the present invention, the dopant of the first conductivity type may be a P-type dopant, and the dopant of the second conductivity type may be an N-type dopant. However, in another example, the dopant of the first conductivity type may be an N-type dopant, and the dopant of the second conductivity type may be a P-type dopant.

When the dopant of the first conductivity type is a P-type dopant and the dopant of the second conductivity type is an N-type dopant, the P-type dopant may include at least one of boron (B), aluminum (Al), gallium (Ga), and indium (In), and the N-type dopant may include at least one of phosphorus (P), arsenic (As), and antimony (Sb).

The pixel isolation structure (140) according to an embodiment of the present invention may electrically isolate each of the pixels (P1, P2) by penetrating the substrate (110). That is, regions in which the pixels (P1, P2) are formed are defined by the pixel isolation structure (140), and the pixels (P1, P2) are electrically isolated from each other by the pixel isolation structure (140). According to one embodiment of the present invention, the pixel isolation structure (140) extends from the first surface (110a) of the substrate (110) to the second surface (110b) of the substrate (110).

According to one embodiment of the present invention, the pixel isolation structure (140) may be formed as a deep trench isolation (DTI) structure in which an insulating layer is filled in a deep trench formed to penetrate the substrate (110) from the first surface (110a) toward the second surface (110b).

As described above, according to the present invention, since the pixel isolation structure (140) for isolating each of the pixels (P1, P2) is continuously formed from the first surface (110a) to the second surface (110b) of the substrate (110), leakage current between adjacent pixels (P1, P2) can be prevented. Specifically, the pixel isolation structure (140) may be disposed to surround each of the plurality of pixels (P1, P2). In addition, in a plan view, the pixel isolation structure (140) may be disposed to surround a plasmonic pattern (151), which will be described below.

A first doping region (121), heavily doped with a dopant of the second conductivity type, is formed on the second surface (110b) of the substrate (110). The first doping region (121) may be formed to have a predetermined thickness on the second surface (110b) of the substrate (110). The first doping region (121) may form a cathode region of the single-photon avalanche diode. As described above, the avalanche amplification region (130) is formed by a PN junction between a region in the substrate (110) doped with a dopant of the first conductivity type and the first doping region (121) doped with a dopant of the second conductivity type.

In one embodiment of the present invention, as shown in FIGS. 3 and 4, the first doping region (121) may be formed to be surrounded by the pixel isolation structure (140) in a plan view. That is, the pixel isolation structure (140) formed in the substrate (110) may have a closed-loop shape surrounding the first doping region (121) in a plan view.

The avalanche amplification region (130) is a region in which multiplication of electrons and holes occurs. In the avalanche amplification region (130), a very strong electric field is formed under a reverse bias condition, allowing electrons to move rapidly. As a result, an electron-hole pair generated by a single photon generates additional electrons, and the generated electrons are accelerated by the electric field and collide with other atoms to generate additional electron-hole pairs in a chain reaction, thereby producing a very high current.

Due to the avalanche amplification region (130), the single-photon avalanche diode is capable of detecting a single photon, thereby enabling detection of extremely low optical signals. Accordingly, it can be effectively applied to sensing in low-light environments.

A second doping region (122), heavily doped with a dopant of the first conductivity type, is formed on the second surface (110b) of the substrate (110). The second doping region (122) may be formed to have a predetermined thickness on the second surface (110b) of the substrate (110). The second doping region (122) may form an anode region of the single-photon avalanche diode.

Referring to FIGS. 3 and 4, the second doping region (122) may have a closed-loop shape surrounding the first doping region (121).

According to one embodiment of the present invention, a plasmonic pattern (151) may be disposed on the first surface (110a) of the substrate (110). The plasmonic pattern (151) according to the present invention may include one or more holes (155). Specifically, the hole (155) according to the present invention is an opening that exposes the first surface (110a) of the substrate (110), and refers to a region surrounded by a remaining portion of the plasmonic pattern (151) after etching.

Although FIG. 2 illustrates the plasmonic pattern (151) as having a rectangular shape, the present invention is not limited thereto. Referring to FIGS. 2 and 4, the holes (155) of the plasmonic pattern (151) may be arranged in a row along a predetermined direction and may be spaced apart from one another. However, the arrangement of the plasmonic pattern (151) is not limited thereto and may be determined as needed. A spacing of the plasmonic pattern (151) may range from several nanometers (nm) to several micrometers (µm).

In addition, according to the present invention, one plasmonic pattern (151) may be disposed for each of the plurality of pixels (P). For example, referring to FIG. 2, one plasmonic pattern (151) may be disposed in each of the first pixel (P1) and the second pixel (P2).

The plasmonic pattern (151) may be an ultrathin metal film and may include a metal material having a high free-electron density to induce plasmon excitation. For example, the plasmonic pattern (151) may include aluminum (Al), gold (Au), or silver (Ag). However, the present invention is not limited thereto, and the plasmonic pattern (151) may be formed of a metal material capable of forming a Schottky barrier with the substrate (110).

Such a Schottky barrier is formed at the junction between the metal and the semiconductor substrate, and assists excited electrons generated in the plasmonic pattern (151) to be efficiently injected into the substrate (110). Accordingly, the efficiency of converting optical energy induced by the plasmonic structure into an electrical signal is improved, rather than being lost through simple reflection or heat.

The plasmonic pattern (151) may be precisely formed using, for example, an Atomic Layer Deposition (ALD) process. A plasmonic phenomenon occurs at a surface or an interface of the plasmonic pattern (151), particularly near a boundary with a dielectric layer (160), thereby inducing a strong near-field.

Such a near-field concentrates and delivers optical energy to the underlying avalanche amplification region (130), thereby improving light absorption efficiency and maximizing charge generation efficiency.

As a result, the plasmonic pattern (151) according to an embodiment of the present invention effectively compensates for optical loss that may occur between the dielectric layer (160) and the substrate (110), while simultaneously enhancing charge collection efficiency through the Schottky barrier junction.

Accordingly, the pixel array (100) including the plasmonic pattern (151) according to the present invention can realize a high-sensitivity image sensor having excellent sensitivity and signal conversion efficiency while minimizing optical loss compared to conventional structures.

However, even when a plasmonic pattern is included, due to the energy bandgap characteristics of a silicon (Si) substrate (for example, about 1.1 eV), the wavelength that the substrate can absorb is limited to approximately 1100 nm or less. Therefore, even if the plasmonic pattern exhibits high light-absorbing properties, there is a limitation in that light in the SWIR (Short-Wavelength Infrared) region cannot be absorbed by the silicon substrate.

To address this limitation, the plasmonic pattern (151) according to the present invention may be configured to include a plurality of holes (155). Such a hole structure serves to convert incident light in the SWIR (Short-Wavelength Infrared) region into a shorter wavelength region that can be absorbed by the substrate (110), through scattering or resonance effects. As a result, light having SWIR wavelengths can be efficiently absorbed by the silicon substrate, thereby significantly improving overall light detection efficiency.

According to one embodiment of the present invention, the plasmonic pattern (151) may be formed as an integral structure. The plasmonic pattern (151) forms a Schottky barrier with the substrate (110) and, at the same time, generates a strong near-field by exciting plasmons on the surface of the plasmonic pattern (151) due to incident photons. In order to efficiently generate such plasmonic effects, the collective oscillation of free electrons within the plasmonic pattern (151) must be continuously transmitted throughout the entire plasmonic pattern (151).

In addition, the plasmonic pattern (151) forms a Schottky barrier with the substrate (110) and serves as a pathway for efficiently injecting electrons generated by optical excitation. If the plasmonic pattern (151) is not continuous, the electron injection path may be non-uniformly formed, or the current path may be interrupted in certain regions, thereby reducing charge collection efficiency.

Therefore, the plasmonic pattern (151) should be integrally formed in order to stably maintain the collective oscillation of plasmons and to uniformly secure the charge injection path through the Schottky barrier.

According to one embodiment of the present invention, when the wavelength of incident light is λ, the thickness of the plasmonic pattern (151) may be maintained within a range of λ/10 to λ/1.3. For example, when the wavelength of the incident light is 1550 nm, which is a central wavelength in the SWIR (Short-Wavelength Infrared) region, the thickness of the plasmonic pattern (151) may be formed within a range of 155 nm to 1192 nm. Within this thickness range, the free electron density inside the metal and the surface plasmon resonance condition can be optimally matched, thereby maximizing the plasmonic resonance intensity with respect to the incident light.

Within this thickness range, the collective oscillation of free electrons in the plasmonic pattern (151) is optimally matched with the internal electron density of the metal and the surface plasmon resonance conditions, thereby maximizing the plasmonic resonance intensity with respect to the incident light. In other words, the thickness of the plasmonic pattern (151) is a key factor that determines the resonance frequency and resonance strength of plasmons, and when the thickness is controlled within the above range, a strong near-field can be induced at the metal surface.

If the thickness of the plasmonic pattern (151) is thinner than the above lower limit, the collective oscillation of free electrons within the plasmonic pattern (151) may not be sufficiently formed, resulting in incomplete plasmon resonance and a weakened near-field intensity. Consequently, the optical energy induced in the plasmonic pattern (151) may not be sufficiently delivered to the substrate (110), thereby reducing charge generation and injection efficiency.

Conversely, if the thickness of the plasmonic pattern (151) exceeds the above upper limit, electron oscillations within the plasmonic pattern (151) may be attenuated or plasmon resonance modes may be suppressed, leading to reduced light absorption efficiency. In addition, excessive thickness may cause non-uniform gap-fill during etching of the plasmonic pattern (151) or deposition of the dielectric layer (160), thereby impairing manufacturing process stability.

Therefore, by limiting the thickness of the plasmonic pattern (151) to approximately 1/10 to 1/1.3 of the incident light wavelength λ, the present invention can maximize the plasmonic resonance effect while simultaneously securing manufacturing process stability and electrical and optical uniformity.

According to one embodiment of the present invention, the hole (155) may have a first length in a first direction (X), and a second length different from the first length in a second direction (Y) perpendicular to the first direction (X). For example, the hole (155) according to the present invention may have a slit shape.

For example, as shown in FIG. 2, a plurality of holes (155) may be disposed, and the plurality of holes (155) may include first holes (155a) having a first length shorter than the second length, and second holes (155b) having a first length longer than the second length.

According to one embodiment of the present invention, one of the first length and the second length may be at least three times greater than the other length. For example, in the case of the first hole (155a), the second length may be at least three times greater than the first length.

According to one embodiment of the present invention, the plurality of holes (155) may be formed to have a predetermined aspect ratio in order to improve light transmission to the substrate (110) and wavelength conversion efficiency when the wavelength of incident light falls within the SWIR region.

For example, the second hole (155b) may have a first length (Lx) in a first direction (X) and a second length (Ly) in a second direction (Y) perpendicular to the first direction (X). A ratio (Lx:Ly) of the first length (Lx) in the first direction (X) to the second length (Ly) in the second direction (Y) may be about 3:1 or greater. For example, the second hole (155b) may have a second length (Ly) of 200 nm or more. Preferably, the second hole (155b) may have a second length (Ly) of 1.5 µm. However, the present invention is not limited thereto.

By satisfying such an aspect ratio, the electromagnetic field distribution generated when incident light passes through the hole (155) becomes more strongly localized in the vertical direction, thereby increasing the intensity of the near-field induced by plasmonic resonance. Accordingly, scattering loss of light is minimized while transmittance and wavelength conversion efficiency are improved.

Conversely, if the aspect ratio of the hole (155) is less than 1:3, the effective aperture area within the hole decreases, making it difficult to secure transmission efficiency for light in the SWIR region. As a result, the light absorption rate and charge generation efficiency in the silicon substrate (110) may be reduced.

Therefore, by forming the hole (155) such that the aspect ratio between the first direction (X) and the second direction (Y) is approximately 1:3 or greater (or 3:1 or greater in the case of the second hole (155b)), the present invention can maximize wavelength conversion and near-field enhancement effects, thereby enabling the silicon substrate to efficiently absorb light in the SWIR wavelength band.

According to one embodiment of the present invention, in a plan view, a pixel (P) may include a first region (areal) and a second region (area2) that are different from each other. For example, FIG. 2 illustrates that the first pixel (P1) includes the first region (area1) and the second region (area2). The first region (area1) may be disposed on one side of the pixel (P), and the second region (area2) may be disposed on the other side of the pixel (P).

A first hole (155a) may be disposed in the first region (area1), and a second hole (155b) may be disposed in the second region (area2). Specifically, holes extending in different directions may be disposed in the first region (area1) and the second region (area2), respectively. For example, in the first region (area1), the first hole (155a) extending in the first direction (X) may be disposed, and in the second region (area2), the second hole (155b) extending in a second direction (Y) perpendicular to the first direction (X) may be disposed. However, the present invention is not limited thereto, and the second hole (155b) may be disposed in the first region (area1), while the first hole (155a) may be disposed in the second region (area2).

In the present invention, the reason for configuring the pixel (P) to include regions in which holes are arranged in different directions is to prevent a problem in which plasmonic resonance selectively occurs depending on the polarization orientation of the incident light.

That is, since surface plasmons of the plasmonic pattern (151) are primarily excited along the longitudinal direction of the holes (155), if the holes (155) are aligned in only one direction, a strong near-field may be formed only for a specific polarization, while the resonance efficiency for a polarization perpendicular thereto may be significantly reduced.

Therefore, the pixel (P) according to the present invention is designed such that the holes (155a, 155b) disposed in the first region (area1) and the second region (area2) are arranged in mutually orthogonal directions, thereby ensuring that the wavelength conversion effect in the SWIR region is stably maintained regardless of the polarization direction of the incident light.

To this end, the first hole (155a) extending in the first direction (X) may be disposed in the first region (area1), and the second hole (155b) extending in the second direction (Y) perpendicular to the first direction (X) may be disposed in the second region (area2).

As described above, by arranging hole structures extending in mutually perpendicular directions within a pixel, surface plasmon resonance in the plasmonic pattern (151) can occur uniformly regardless of the polarization state of the incident light (horizontal, vertical, or diagonal polarization). As a result, wavelength conversion efficiency and the efficiency of optical energy transfer to the substrate (110) are significantly improved across the entire SWIR wavelength range.

According to one embodiment of the present invention, a barrier layer (145) may be disposed on the first surface (110a) of the substrate (110). The barrier layer (145) may include titanium nitride (TiN). However, the present invention is not limited thereto, and the barrier layer (145) may include a conductive material. In a plan view, the barrier layer (145) may have the same area as the plasmonic pattern (151). Specifically, the barrier layer (145) may be formed by the same etching process used to form the plasmonic pattern (151).

The barrier layer (145) according to the present invention may be disposed between the substrate (110) and the plasmonic pattern (151), and may be in contact with the first surface (110a) of the substrate (110) and the plasmonic pattern (151), respectively.

The barrier layer (145) according to the present invention serves to secure junction stability between the substrate (110) and the plasmonic pattern (151), suppressing interfacial reactions between the metal and the semiconductor and improving uniformity of the charge injection path.

More specifically, when a metal layer directly contacts a semiconductor substrate, metal atoms may diffuse into the substrate or a reaction layer may be formed at the interface depending on process temperature or prolonged operation, thereby destabilizing junction characteristics. To prevent such problems, the present invention forms the barrier layer (145) having a thickness of several tens of nanometers (nm) on the substrate (110), thereby stabilizing formation of a Schottky barrier between the metal and the semiconductor. For example, the barrier layer (145) may have a thickness of 10 to 90 nm.

In addition, since the barrier layer (145) is conductive, electrons excited in the plasmonic pattern (151) can be smoothly injected into the substrate (110) through the barrier layer (145). As a result, charge transfer resistance between the metal layer and the semiconductor substrate is reduced, and electron-hole pairs induced by plasmonic resonance are efficiently collected, thereby improving signal conversion efficiency.

According to one embodiment of the present invention, a dielectric layer (160) may be disposed on the plasmonic pattern (151). Specifically, the dielectric layer (160) may be in contact with the plasmonic pattern (151) and may fill the holes (155). Referring to FIG. 4, the dielectric layer (160) serves to planarize the surface of the pixel array (100), thereby improving the precision of subsequent processes and compensating for surface level differences between various device layers.

In addition, the dielectric layer (160) may control the surface plasmon resonance phenomenon occurring within the plasmonic pattern (151). That is, the electric field intensity of the near-field formed within the holes (155) of the plasmonic pattern (151) varies depending on the refractive index (n) of the dielectric layer (160), thereby enabling fine adjustment of wavelength conversion efficiency.

Accordingly, the dielectric layer (160) functions to stably maintain plasmonic resonance conditions and to enhance optical signal responsivity.

Meanwhile, the dielectric layer (160) may be formed of a material such as silicon oxide (SiO₂, n≈1.4), titanium oxide (TiO₂, n>2.0), or silicon nitride (SiNₓ, n≈2.0). The resonance condition with the plasmonic pattern (151) may vary depending on the refractive index of the material.

An image sensor (600) according to one embodiment of the present invention may include the substrate (110), an intermediate layer (690) disposed below the substrate (110), and a readout circuit (700) disposed below the intermediate layer (690). Specifically, the intermediate layer (690) may be disposed between the substrate (110) and the readout circuit (700).

In the intermediate layer (690) according to the present invention, a first contact portion (164), a second contact portion (165), a first metal pad (167), and a second metal pad (168) may be disposed.

According to one embodiment of the present invention, the first contact portion (164) and the first metal pad (167) may constitute a cathode electrode portion, and the second contact portion (165) and the second metal pad (168) may constitute an anode electrode portion.

According to the present invention, a plurality of metal interconnections (710) may be disposed in the readout circuit (700). Although not shown in FIG. 4, the plurality of metal interconnections (710) may be spaced apart from one another by a plurality of interlayer insulating films (not shown).

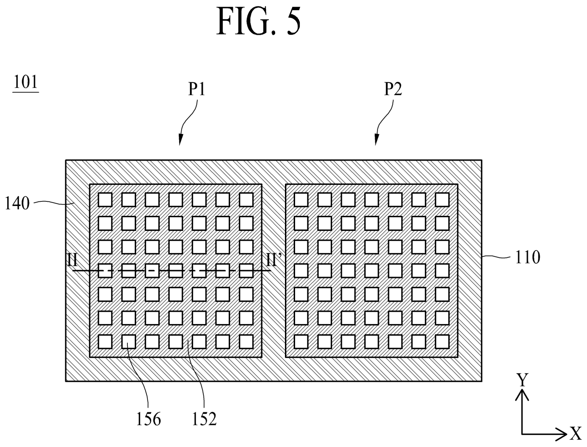

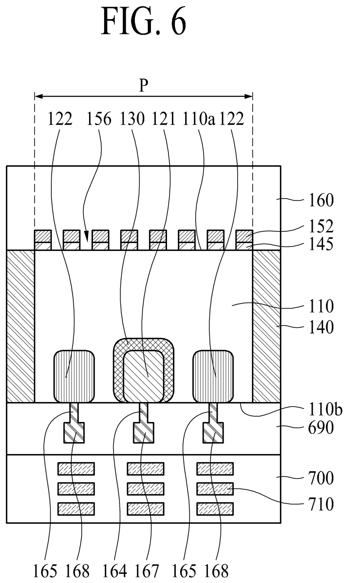

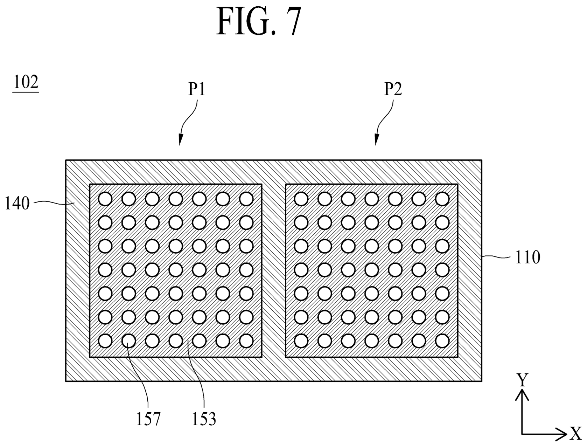

FIG. 5 is a plan view of a pixel array (101) according to another embodiment of FIG. 2. FIG. 6 is a cross-sectional view taken along line II-II' of FIG. 5. FIG. 7 is a plan view of a pixel array (102) according to another embodiment of FIG. 2.

Unlike the pixel array (100) shown in FIGS. 2 and 4, referring to FIG. 5, the plasmonic pattern (152) may include a hole (156) having a first length in a first direction (X) and a second length equal to the first length in a second direction (Y) perpendicular to the first direction (X). For example, FIG. 5 illustrates the hole (156) as having a square shape. However, the present invention is not limited thereto, and the hole (156) may have a circular shape (see FIG. 7).

According to one embodiment of the present invention, the hole (156) included in the plasmonic pattern (152) may have a square structure with equal lengths in the first direction (X) and the second direction (Y), or a circular structure having a constant radius. That is, the hole (156) may have an aspect ratio of 1:1.

A hole (156) having such an aspect ratio allows electromagnetic field components in vertical and horizontal directions to be evenly distributed with respect to the propagation direction of incident light, thereby providing an isotropic plasmonic resonance condition that is independent of polarization. Accordingly, a constant wavelength conversion efficiency can be maintained regardless of the polarization state or angle of incidence of the incident light.

In addition, a width or diameter of the hole (156) may be maintained within a range of λ/4 to λ/1.5, and more specifically within a range of λ/2.6 to λ/1.5, relative to the wavelength (λ) of the incident light. Within this dimensional range, the hole (156) can induce strong electromagnetic field coupling within a region corresponding to half the wavelength (λ/2) of the incident light, thereby maximizing the plasmonic effect within the plasmonic pattern (152).

Therefore, the width or diameter of the hole (156) may be maintained within a range of λ/4 to λ/1.5 relative to the wavelength (λ) of the incident light.

If the above range is not satisfied, it may be difficult to implement the pattern through an etching process, or it may be difficult to achieve the desired plasmonic effect.

Accordingly, the plasmonic pattern (152) according to the present invention may be designed such that the width or diameter of the hole (156) is maintained within a range of 200 nm to 1000 nm in order to achieve efficient wavelength conversion in the SWIR wavelength band (e.g., a central wavelength of 1550 nm). More specifically, it may be designed to be maintained within a range of 400 nm to 1000 nm. Preferably, it may be in a range of 600 nm to 1000 nm. Through such a structure, even though the hole (156) has a simple configuration, the electromagnetic field distribution in both vertical and horizontal directions can be uniformly maintained. As a result, the plasmonic resonance condition is stabilized, thereby simultaneously improving light absorption efficiency and conversion efficiency.

The pixel array (102) shown in FIG. 7 includes a plasmonic pattern (153) having circular holes (157). In the case of the pixel array (102) shown in FIG. 7, the same technical effects as those of the pixel array (101) shown in FIGS. 5 and 6 may be achieved. Repetitive descriptions overlapping with those provided with respect to FIGS. 5 and 6 will be omitted.

Referring to FIGS. 5 to 7, when the wavelength of incident light is λ, the thickness of the plasmonic patterns (152, 153) may be maintained within a range of λ/10 to λ/1.3. For example, when the wavelength of the incident light is 1550 nm, which is the central wavelength of the SWIR (Short-Wavelength Infrared) region, the thickness of the plasmonic pattern (152, 153) may be formed within a range of 155 nm to 1192 nm. Since the thickness of the plasmonic patterns (152, 153) overlaps with the description provided with respect to FIG. 4, a detailed explanation thereof will be omitted.

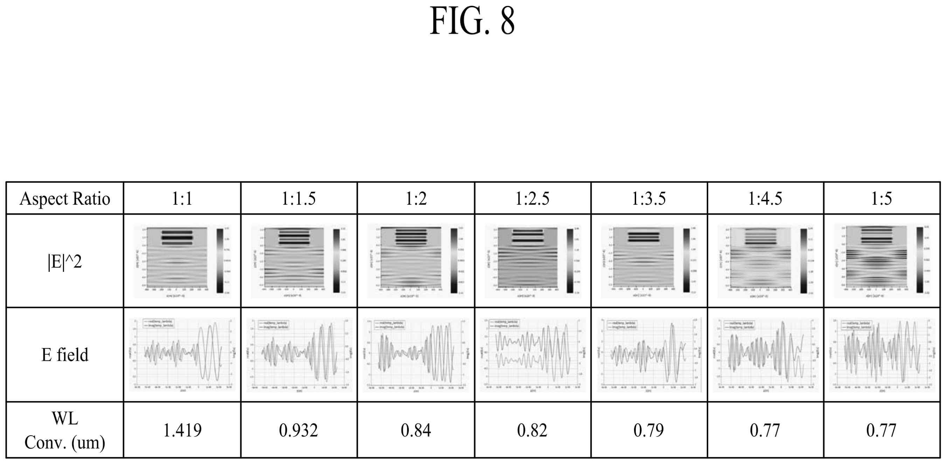

FIG. 8 is a table showing wavelength conversion according to the aspect ratio of the hole.

Referring to FIGS. 2, 4, and 8, it can be confirmed that as the aspect ratio of the hole (155) increases, the electromagnetic field distribution (E-field distribution) and wavelength conversion characteristics significantly change.

Specifically, the |E|² distribution (first column of FIG. 8) represents results obtained through FDTD simulation. As the aspect ratio of the hole (155) increases from 1:1 to 1:5, the electric field in the hole (155) region of the plasmonic pattern (151) becomes more densely concentrated in a striped pattern. This indicates that the near-field formed when incident light passes through the hole becomes more strongly localized as the aspect ratio increases. In particular, the upper portion of the image represents the region where the plasmonic pattern is disposed, and the lower portion represents the substrate (110). The vertical axis at 0 (z = 0) corresponds to the first surface (110a), or the upper surface, of the substrate (110).

In addition, in the |E|² distribution, stripes corresponding to regions where the electric field intensity (|E|²) reaches a maximum (i.e., intensity maxima bands) are periodically repeated, and the spacing between adjacent intensity maxima bands corresponds to half the wavelength (λ/2). As can be confirmed from the overall results of FIG. 8, as the aspect ratio increases (from 1:1 to 1:5), the half-wavelength gradually decreases. This indicates that, when the same incident light (1550 nm) is irradiated, the electric field period inside the hole is shortened, thereby enabling more efficient wavelength conversion.

The same tendency is observed in the E-field graph shown in the second row of FIG. 8. The horizontal axis of the graph represents the position in the z-axis direction based on the cross-sectional view of FIG. 4, where 0 corresponds to the upper surface of the substrate (110), the positive (+) direction indicates the direction toward the plasmonic pattern (151), and the negative (-) direction indicates the direction toward the interior of the substrate (110). In the graph, regions where the real and imaginary components of the electric field intersect and exhibit increased amplitude correspond to locations where plasmonic resonance occurs. When the aspect ratio is 1:3 or greater, this amplitude noticeably increases, indicating more pronounced near-field enhancement and wavelength shortening effects.

The last row of the table, labeled WL Conv (µm), represents the converted effective wavelength with respect to the incident light (1550 nm). When the aspect ratio is 1:1, the effective wavelength is approximately 1.419 µm, indicating almost no change. However, when the aspect ratio is 1:5, the effective wavelength is significantly shortened to approximately 0.7 µm. This means that as the aspect ratio increases, electromagnetic resonance within the hole is strengthened, and consequently, the wavelength of light entering the substrate (110) becomes shorter.

From these results, it can be confirmed that, in the present invention, wavelength conversion and electric field localization are effectively achieved when the aspect ratio of the hole (155) is 1:3 or greater. Therefore, by designing the aspect ratio to be 1:3 or greater, incident light in the SWIR (Short-Wavelength Infrared) region can be efficiently absorbed by the substrate (110), thereby improving photo-to-charge conversion efficiency while minimizing optical loss and achieving an optimal structure.

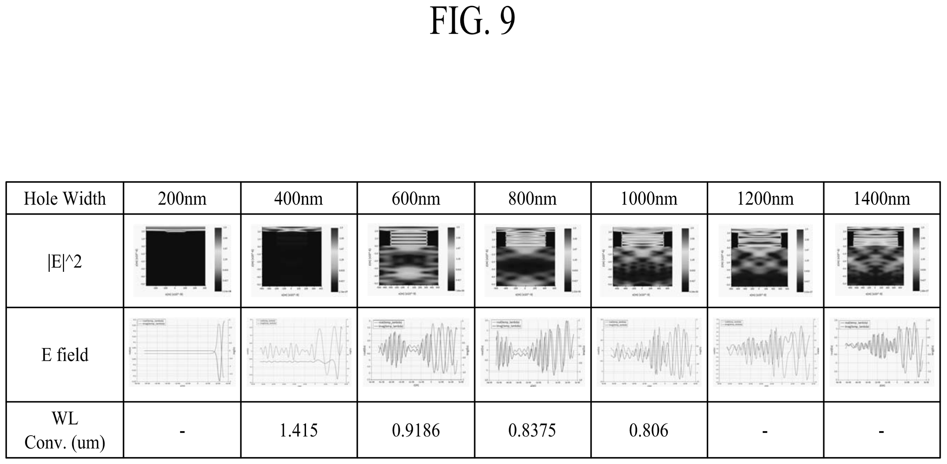

FIG. 9 is a table showing wavelength conversion according to the width of the hole.

Referring to FIGS. 5 to 7 and 9, it can be confirmed that as the width of the holes (156, 157) increases, the electromagnetic field distribution (E-field distribution) and wavelength conversion characteristics change significantly. Specifically, the width may correspond to the spacing between plasmonic patterns (152) shown in FIG. 6, or to the diameter of the hole (157) shown in FIG. 7.

More specifically, the |E|² distribution (first column of FIG. 9) represents results obtained through FDTD simulation. As the width of the holes (156, 157) increases from 400 nm to 1,000 nm, the electric field in the hole regions of the plasmonic patterns (152, 153) becomes more densely concentrated in a striped pattern. This indicates that the near-field formed when incident light passes through the hole becomes more strongly localized as the width increases. In particular, the upper portion of the image represents the region where the plasmonic pattern is disposed, and the lower portion represents the substrate (110). The vertical axis at 0 (z = 0) corresponds to the first surface (110a), or upper surface, of the substrate (110).

In addition, in the |E|² distribution, stripes corresponding to regions where the electric field intensity (|E|²) reaches a maximum (i.e., intensity maxima bands) are periodically repeated, and the spacing between adjacent intensity maxima bands corresponds to a half of the wavelength (λ/2). As can be confirmed from the overall results of FIG. 9, as the width increases (400 nm to 1,000 nm), the half-wavelength gradually decreases. This indicates that, when the same incident light (1550 nm) is irradiated, the electric field period inside the hole is shortened, thereby enabling more efficient wavelength conversion.

The same tendency is observed in the E-field graph shown in the second row of FIG. 9. The horizontal axis of the graph represents the position in the z-axis direction based on the cross-sectional view of FIG. 6, where 0 corresponds to the upper surface of the substrate (110), the positive (+) direction indicates the direction toward the plasmonic pattern (152), and the negative (-) direction indicates the direction toward the interior of the substrate (110). Regions in which the real and imaginary components of the electric field intersect and exhibit increased amplitude correspond to plasmonic resonance locations. When the width is in the range of 400 nm to 1,000 nm, this amplitude increases noticeably, resulting in more pronounced near-field enhancement and wavelength shortening effects.

The last row of the table, labeled WL Conv (µm), represents the converted effective wavelength with respect to the incident light (1550 nm). When the width is 200 nm, 1,200 nm, or 1,400 nm, it is difficult to measure the effective wavelength. However, when the width is in the range of 400 nm to 1,000 nm, a wavelength change is clearly observed. This indicates that, with respect to an incident wavelength of 1550 nm, electromagnetic resonance within holes having widths in the range of 400 nm to 1,000 nm is enhanced, and as a result, the wavelength of light entering the substrate (110) becomes shorter.

From these results, it can be confirmed that, in the present invention, wavelength conversion and electric field localization are effectively achieved when the width of the holes (156, 157) relative to the incident wavelength (λ) is within a range of λ/4 to λ/1.5. Therefore, by designing the width of the holes (156, 157) to be within a range of λ/4 to λ/1.5 relative to the incident wavelength (λ), incident light in the SWIR region can be efficiently absorbed by the substrate (110), thereby improving photo-to-charge conversion efficiency while minimizing optical loss and achieving an optimal structure.

According to the present disclosure, the following advantageous effects may be obtained.

A pixel array according to one embodiment of the present invention can maximize light absorption efficiency at SWIR wavelengths by inducing wavelength conversion using the structure of a plasmonic pattern.

In addition to the effects mentioned above, other features and advantages of the present invention are described below or may be clearly understood by those skilled in the art to which the present invention pertains from such description and explanation.

It will be apparent to those skilled in the art that the present disclosure described above is not limited by the above-described embodiments and the accompanying drawings and that various substitutions, modifications and variations can be made in the present disclosure without departing from the scope of the disclosures. Consequently, the scope of the present disclosure is defined by the accompanying claims and it is intended that all variations or modifications derived from the meaning, scope and equivalent concept of the claims fall within the scope of the present disclosure.

## Claims

1. A pixel array comprising:
a plurality of pixels,
wherein each of the plurality of pixels comprises:
a substrate including an avalanche amplification region and having a first surface on which light from the outside is incident; and
a plasmonic pattern formed on the first surface of the substrate,
wherein the plasmonic pattern includes one or more holes.

2. The pixel array according to claim 1, wherein one plasmonic pattern is disposed for each of the plurality of pixels.

3. The pixel array according to claim 1 or 2, wherein the plasmonic pattern disposed in any one of the plurality of pixels is formed as an integral structure.

4. The pixel array according to any one of claims 1-3, wherein the plasmonic pattern includes a plurality of holes arranged in a predetermined direction, wherein the plurality of holes are spaced apart from each other.

5. The pixel array according to any one of the preceding claims, wherein the hole has a first length in a first direction, and a second length different from the first length in a second direction perpendicular to the first direction.

6. The pixel array according to claim 5, wherein one of the first length and the second length is at least three times greater than the other.

7. The pixel array according to claim 5 or 6, wherein, in a plan view, the pixel includes a first region and a second region different from each other,
wherein the plasmonic pattern includes a plurality of holes disposed in the first region and the second region, and
wherein the plurality of holes disposed in the first region and the plurality of holes disposed in the second region extend in directions perpendicular to each other.

8. The pixel array according to any one of the preceding claims, wherein the hole has a square shape in a plan view or has a circular shape having a constant radius in a plan view.

9. The pixel array according to claim 8, wherein, when a wavelength of incident light is λ, a width of the hole is in a range from λ/4 to λ/1.5.

10. The pixel array according to any one of the preceding claims, wherein the width of the hole is in a range from 400 nm to 1,000 nm.

11. The pixel array according to any one of the preceding claims, comprising: a barrier layer disposed between the substrate and the plasmonic pattern and being in contact with the first surface of the substrate and the plasmonic pattern; and
a dielectric layer disposed on the plasmonic pattern and filling the hole.

12. An image sensor comprising:
a plurality of pixels; and
a pixel isolation structure separating the plurality of pixels from one another,
wherein each of the plurality of pixels comprises:
a substrate disposed on a readout circuit and having a first surface on which light from the outside is incident; and
a plasmonic pattern formed on the first surface of the substrate,
wherein the plasmonic pattern includes a plurality of holes.

13. The image sensor according to claim 12, wherein one plasmonic pattern is disposed for each of the plurality of pixels.

14. The image sensor according to claim 12 or 13, wherein the plasmonic pattern disposed in any one of the plurality of pixels is formed as an integral structure.

15. The image sensor according to any one of claim 12, 13 or 14wherein the plasmonic pattern includes a plurality of holes arranged in a predetermined direction, wherein the plurality of holes are spaced apart from each other.
